# EUROPEAN PATENT APPLICATION

(11) **EP 4 706 961 A1**
(43) Date of publication of application: **11.03.2026**
(21) Application number: 24800097.8
(22) Date of filing: 26.04.2024
(51) Int. Cl.: B32B 27/28, B29C 48/08, B29C 55/04, B32B 9/00, B65D 65/40

(54) **MULTILAYER STRUCTURE, MOLDED BODY, CONTAINER, FOOD CONTAINER, AND METHOD FOR PRODUCING MULTILAYER STRUCTURE**

(30) Priority: 01.05.2023 JP 2023075515
(71) Applicant: Mitsubishi Chemical Corporation, Tokyo 100-8251 (JP)
(72) Inventor: YAMAMOTO Nobuyuki, Tokyo 100-8251 (JP)
(74) Representative: Hoffmann Eitle
(86) International application number: PCT/JP2024/016399
(87) International publication number: WO 2024/228366

(57) **Abstract**

A multilayer structure has excellent barrier properties and including: a layer (A) comprising an ethylene-vinyl alcohol copolymer; and an inorganic vapor-deposited layer (B) adjacent to the layer (A). The layer (A) is extrusion molded and uniaxially stretched, and the ethylene-vinyl alcohol copolymer has a single ethylene unit content.

## Description

### Technical Field

The present disclosure relates to a multilayer structure, and more particularly, to a multilayer structure having excellent barrier properties.

### Background Art

An ethylene-vinyl alcohol copolymer (hereinafter, which may be referred to as an "EVOH resin") exhibits a very strong intermolecular force due to hydrogen bonding between hydroxyl groups present in the polymer side chains. For this reason, an EVOH resin exhibits high crystallinity and also possesses high intermolecular force even in the amorphous portion, and therefore, gas molecules or the like do not easily pass through a film in which an EVOH resin is used, and hence such films exhibit excellent gas barrier properties. Thus, an EVOH resin is used as a gas barrier layer for imparting gas barrier properties to a multilayer structure such as a film or a container in a wide range of fields such as food packaging.

For example, JP 2022-009162 A discloses, as an example, a gas barrier laminate in which a carbon-containing silicon oxide vapor-deposited film is formed on a biaxially stretched multilayer substrate having an EVOH resin as a surface resin layer.

Further, WO 2021/210606 A1 discloses, as an example, a vapor-deposited multilayer film in which aluminum is vapor-deposited on a uniaxially stretched multilayer film in which two types of EVOH having different ethylene unit contents are used.

### Related Art Document

### Patent Literature

Patent Literature 1: JP 2022-009162 A
Patent Literature 2: WO 2021/210606 A1

### Summary

### Technical Problem

In JP 2022-009162 A, a carbon-containing silicon oxide vapor-deposited film is formed on a biaxially stretched multilayer substrate, but when the vapor-deposited film is formed using a biaxially stretched film or the like, the barrier properties tend to be insufficient, and thus there is room for improvement.

In addition, in WO 2021/210606 A1, two types of EVOH resins having different ethylene unit contents are used, but the barrier properties of a vapor-deposited film in which two types of EVOH resins having different ethylene unit contents are used are likely to be insufficient, and thus there is room for improvement.

The present disclosure was developed in view of such problems, and provides a multilayer structure having a layer containing an EVOH resin. The multilayer structure exhibits excellent barrier properties, and particularly an excellent oxygen barrier property.

### Solution to Problem

The present inventors conducted intensive studies to solve the above problems, and as a result, discovered that the barrier properties can be improved by laminating an inorganic vapor-deposited layer on a layer containing an extrusion molded and uniaxially stretched EVOH resin having a single ethylene content.

Specifically, the present disclosure provides the following aspects [1] to [9].
[1] A multilayer structure comprising:
   a layer (A) comprising an EVOH resin; and
   an inorganic vapor-deposited layer (B) adjacent to the layer (A),
   wherein the layer (A) is extrusion molded and uniaxially stretched, and
   wherein the EVOH resin has a single ethylene unit content.
[2] The multilayer structure according to [1], wherein the inorganic vapor-deposited layer (B) comprises an inorganic oxide and/or an inorganic nitride.
[3] The multilayer structure according to [1] or [2], wherein a stretching ratio of the layer (A) is 3 or more times.
[4] The multilayer structure according to any one of [1] to [3], a layer (C) comprising a thermoplastic resin.
[5] The multilayer structure according to [4], wherein the thermoplastic resin comprises a polyolefin.
[6] A molded body comprising the multilayer structure according to any one of [1] to [5].
[7] A container comprising the multilayer structure according to any one of [1] to [5].
[8] A food container comprising the multilayer structure according to any one of [1] to [5].
[9] A method for producing a multilayer structure, the method comprising: uniaxially stretching a layer (A) comprising an EVOH resin, and laminating an inorganic vapor-deposited layer (B) on the layer (A).

### Advantageous Effects

According to the present disclosure, a vapor-deposited film having excellent barrier properties can be obtained by laminating an inorganic vapor-deposited layer on a layer containing an extrusion molded and uniaxially stretched EVOH resin having a single ethylene unit content.

### Description of Embodiments

The present disclosure is described below based on embodiments for carrying out the present disclosure. However, the present disclosure is not limited to the embodiments described below.

In addition, in the present specification, an expression of "from X to Y" (where X and Y are any numbers) includes the meaning of "X or more and Y or less" and the meaning of "preferably greater than X" or "preferably less than Y", unless otherwise specified.

Moreover, an expression of "X or more" (where X is any number) or "Y or less" (where Y is any number) also includes the meaning of "preferably greater than X" or "preferably less than Y".

Further, an expression of "X and/or Y (where X and Y are any configurations)" means at least one of X or Y, and has three meanings including X only, Y only, and both X and Y.

In the present specification, with respect to numerical ranges described in stages, the upper limit value or the lower limit value of a numerical range of a certain stage can be optionally combined with an upper limit value or a lower limit value of a numerical range of another stage. In addition, in a numerical range described in the present specification, the upper limit value or the lower limit value of the numerical range can be replaced with a value presented in the Examples.

Hereinafter, a monomer unit contained in an EVOH resin or thermoplastic resin may be simply referred to as a "unit". For example, a monomer unit based on ethylene may be referred to as an "ethylene unit".

A multilayer structure according to one embodiment of the present disclosure (hereinafter, referred to as "the present multilayer structure") includes a layer (A) containing an EVOH resin (hereinafter, the layer (A) may be referred to as an "EVOH resin layer (A)") and an inorganic vapor-deposited layer (B) adjacent to the layer (A).

Hereinafter, each constituent element will be described.

### EVOH Resin Layer (A)

The EVOH resin layer (A) is formed from an EVOH resin composition containing an EVOH resin.

The EVOH resin can be obtained by saponifying an ethylene-vinyl ester copolymer. A typical example of the vinyl ester is vinyl acetate, but other fatty acid vinyl esters (such as vinyl propionate and vinyl pivalate) can also be used. The ethylene-vinyl ester copolymer is produced by any known polymerization method, for example, solution polymerization, suspension polymerization, and emulsion polymerization, and saponification of the ethylene-vinyl ester copolymer can also be carried out by a known method.

The ethylene unit content of the EVOH resin is a value that is measured based on the ISO 14663 standard, and is usually from 20 to 60 mol%, preferably from 22 to 45 mol%, particularly preferably from 25 to 35 mol%, and most preferably 25 mol% or more but less than 32 mol%. When the ethylene unit content of the EVOH resin is within the above range, transparency of the present multilayer structure tends to be improved.

The EVOH resin used in the present multilayer structure has a single ethylene unit content. That is, the EVOH resin layer (A) does not contain two or more types of EVOH resins having different ethylene unit contents. When two or more types of EVOH resins having different ethylene unit contents are contained in the EVOH resin layer (A), the barrier properties of the present multilayer structure are reduced. The phrase "has a single ethylene unit content" in the present disclosure means that the melting peak in differential scanning calorimetry (DSC) is a single peak having only one apex, and two points at a height (H/2), which is half the height (H) from the baseline to the apex of the peak, are within ±10°C from the apex temperature. The conditions of DSC in the above definition are as follows.

Conditions of DSC: The temperature is raised from 30°C to 230°C at a rate of 10°C/min and then maintained at 230°C for 1 minute, after which the temperature is cooled to 30°C at a rate of 10°C/min and then maintained at 30°C for 1 minute, after which the temperature is raised once again from 30°C to 230°C at a rate of 10°C/min. The shape of the melting peak is confirmed, and the apex temperature of the melting peak is read from a heating chart of the second round of heating, with the vertical axis being the heat capacity, and the horizontal axis being the temperature. Moreover, a straight line connecting a point (point a) that is 20°C higher than the apex temperature of the melting peak and a point (point b) that is 80°C lower than the apex temperature of the melting peak is defined as a baseline.

Note that two or more types of EVOH resins having different types of vinyl esters and different physical properties or the like may be mixed and used as long as the ethylene unit content is the same.

The saponification degree of the vinyl ester unit in the EVOH resin is a value that is measured based on JIS K6726 (provided that the EVOH resin is uniformly dissolved in a water-methanol solvent to form a solution), and from the viewpoints of barrier properties, thermal stability, and moisture resistance, the saponification degree is preferably 80 mol% or greater, more preferably 90 mol% or greater, even more preferably 98 mol% or greater, and particularly preferably 99 mol% or greater, and may be 100 mol%.

The melt flow rate (MFR) (at 210°C and a load of 2160 g) of the EVOH resin is usually from 0.5 to 100 g/10 min, preferably from 1 to 50 g/10 min, and particularly preferably from 3 to 35 g/10 min. When the MFR is too high, the film-forming property tends to be unstable, and when the MFR is too low, the viscosity tends to be too high, resulting in difficulty in carrying out melt extrusion.

The EVOH resin may be copolymerized with a polymerizable monomer besides ethylene and the vinyl ester within a range in which the effects of the present disclosure are not inhibited, that is, generally within a range of 5 mol% or less. Examples of such a polymerizable monomer include an α-olefin such as propylene, isobutene, α-octene, α-dodecene, and α-octadecene; a hydroxy group-containing α-olefin such as 3-buten-1-ol, 4-penten-1-ol, and 3-butene-1,2-diol, and hydroxy group-containing α-olefin derivatives such as an esterified product or an acylated product thereof; hydroxymethylvinylidene diacetates such as 1,3-diacetoxy-2-methylenepropane, 1,3-dipropionyloxy-2-methylenepropane, and 1,3-dibutyronyloxy-2-methylenepropane; an unsaturated carboxylic acid or a salt, a partial alkyl ester, a complete alkyl ester, a nitrile, an amide, or an anhydride thereof; an unsaturated sulfonic acid or a salt thereof; a vinylsilane compound; vinyl chloride; and styrene. One of these may be used alone or two or more thereof may be used in combination.

Further, as the EVOH resin, an EVOH resin that has been subjected to a "post-modification" treatment such as urethanization, acetalization, cyanoethylation, or oxyalkylenation can also be used.

The content of EVOH in the EVOH resin layer (A) is not particularly limited, but the EVOH resin is preferably the main component (that is, the content of the EVOH resin contained in the EVOH resin layer (A) is 50 mass% or greater). The content of the EVOH resin is more preferably 60 mass% or greater, still more preferably 70 mass% or greater, and particularly preferably 80 mass% or greater, 90 mass% or greater, 95 mass% or greater, or 100 mass%.

For example, the EVOH resin layer(A) may contain, besides the EVOH resin, another component within a range that does not inhibit the effect of the present disclosure, and generally within a range of 20 mass% or less. Examples of other components include an anti-blocking agent, a processing aid, a resin other than EVOH resin, a carboxylic acid compound, a phosphoric acid compound, a boron compound, a metal salt, a stabilizer, an antioxidant, an ultraviolet absorber, a plasticizer, an antistatic agent, a lubricant, a colorant, a filler, a surfactant, a desiccant, a crosslinking agent, and a reinforcing agent such as various fibers. One of these may be used alone or two or more thereof may be used in combination.

The thickness of the EVOH resin layer (A) is not particularly limited, but is preferably 0.5 µm or greater, and more preferably 0.8 µm or greater, and may be 1 µm or greater. When the thickness of the EVOH resin layer (A) is 0.5 µm or greater, the gas barrier properties tend to be improved. Moreover, the thickness of the EVOH resin layer (A) is preferably 20 µm or less, and more preferably 10 µm or less, and may be 5 µm or less. When the thickness of the EVOH resin layer (A) is 20 µm or less, the appearance characteristics (of the film surface) tend to be favorable. Note that the thickness of the EVOH resin layer (A) means the thickness after stretching. Moreover, in a case in which the present multilayer structure includes a plurality of EVOH resin layers (A), the total thickness of all the EVOH resin layers (A) is preferably within the above range.

### Inorganic Vapor-Deposited Layer (B)

The present multilayer structure includes an inorganic vapor-deposited layer (B) adjacent to the EVOH resin layer (A). The present multilayer structure exhibits excellent barrier properties by being provided with the inorganic vapor-deposited layer (B) adjacent to the EVOH resin layer (A).

The inorganic vapor-deposited layer (B) need only be adjacent to the EVOH resin layer (A), and for example, the inorganic vapor-deposited layer (B) may be provided on only one side of the EVOH resin layer (A), or the inorganic vapor-deposited layer (B) may be provided on both sides of the EVOH resin layer (A). Among these configurations, the inorganic vapor-deposited layer (B) is preferably provided on only one side of the EVOH resin layer (A) from the viewpoints of productivity and cost.

The inorganic vapor-deposited layer (B) is preferably formed from an inorganic oxide and/or an inorganic nitride from the viewpoint of barrier properties.

Examples of the inorganic oxide and/or the inorganic nitride include inorganic oxides and inorganic nitrides of aluminum, silicon, magnesium, calcium, zirconium, titanium, boron, hafnium, barium, and the like.

Specific examples thereof include inorganic oxides such as aluminum oxide (alumina), silicon oxide (silica), magnesium oxide, calcium oxide, zirconium oxide, titanium oxide, boron oxide, hafnium oxide, and silicon oxycarbide (oxygen-containing silicon oxide), and inorganic nitrides such as silicon nitride and aluminum nitride. Among these, inorganic oxides are preferable, and aluminum oxide (alumina) and silicon oxide (silica) are particularly preferable.

The film thickness (thickness of one layer) of the inorganic vapor-deposited layer (B) is usually from 1 to 100 nm, preferably from 3 to 50 nm, and more preferably from 5 to 20 nm. When the film thickness of the inorganic vapor-deposited layer (B) is less than 1 nm, the barrier properties tends to be insufficient, and on the other hand, even when the film thickness exceeds 100 nm, the improvement effect of the barrier properties cannot be obtained, and the bending resistance and production costs tend to increase.

### Layer (C) Containing Thermoplastic Resin

The present multilayer structure preferably includes a layer (C) containing a thermoplastic resin (hereinafter, the layer (C) is referred to as a "thermoplastic resin layer (C)"). When the present multilayer structure includes the thermoplastic resin layer (C), the mechanical strength and water vapor barrier property of the present multilayer structure tend to be further improved. In addition, properties such as heat sealability and mechanical strength can be imparted depending on the type of the thermoplastic resin constituting the thermoplastic resin layer (C).

The thermoplastic resin is a thermoplastic resin other than the EVOH resin, and examples include polyolefins, including polyethylenes, such as linear low-density polyethylene, low-density polyethylene, ultra low-density polyethylene, medium-density polyethylene, and high-density polyethylene, homopolymers and copolymers of olefins, such as ethylene-vinyl acetate copolymers, ionomers, ethylene-propylene (block or random) copolymers, ethylene-(meth)acrylic acid copolymers, ethylene-(meth)acrylate copolymers, polypropylene, propylene-α-olefin copolymers, polybutene, and polypentene, or those obtained by graft-modifying these polyolefins with unsaturated carboxylic acids or esters thereof; polyesters; polyamides (including copolymerized polyamides); polyvinyl chloride; polyvinylidene chloride; acrylic resins; polystyrene; polyvinyl esters; polyester elastomers; polyurethane elastomers; chlorinated polystyrene; chlorinated polypropylene; aromatic polyketones or aliphatic polyketones, and polyalcohols obtained by reducing these; polyacetals; and polycarbonates. Among these, from the viewpoint of excelling in heat sealability and mechanical properties, polyolefins are preferable, polypropylene and polyethylene are more preferable, and polyethylene is particularly preferable. One of these may be used alone or two or more thereof may be used in combination.

When polyethylene is used as the thermoplastic resin, the melt flow rate (MFR) of the polyethylene measured in accordance with JIS K 7210:2014 (at 190°C and a load of 2160 g) is preferably from 0.10 to 7.5 g/10 min, more preferably from 0.15 to 5.0 g/10 min, and particularly preferably from 0.2 to 2.5 g/10 min. When the MFR of the polyethylene is within the above range, the molding stability tends to be further improved.

The content of the thermoplastic resin in the thermoplastic resin layer (C) is not particularly limited, but the thermoplastic resin is preferably the main component (that is, the content of the thermoplastic resin contained in the thermoplastic resin layer (C) is 50 mass% or greater). The content of the thermoplastic resin is more preferably 60 mass% or greater, still more preferably 70 mass% or greater, and particularly preferably 80 mass% or greater, 90 mass% or greater, 95 mass% or greater, or 100 mass%.

For example, the thermoplastic resin layer (C) may contain, in addition to the thermoplastic resin, another component within a range that does not inhibit the effect of the present disclosure, and generally within a range of 20 mass% or less. Examples of other components include an anti-blocking agent, a processing aid, a resin other than a thermoplastic resin, a carboxylic acid compound, a phosphoric acid compound, a boron compound, a metal salt, a stabilizer, an antioxidant, an ultraviolet absorber, a plasticizer, an antistatic agent, a lubricant, a colorant, a filler, a surfactant, a desiccant, a crosslinking agent, and a reinforcing agent such as various fibers. One of these may be used alone or two or more thereof may be used in combination.

The thickness of the thermoplastic resin layer (C) is not particularly limited, but is usually from 1 to 100 µm, preferably from 2 to 80 µm, and more preferably from 5 to 50 µm. The thickness of the thermoplastic resin layer (C) means the thickness after stretching in a case of stretching. In addition, in a case in which the present multilayer structure includes a plurality of thermoplastic resin layers (C), the total thickness of all the thermoplastic resin layers (C) is preferably within the above range.

### Layer (D) Containing Adhesive Resin

The present multilayer structure may include a layer (D) containing an adhesive resin (hereinafter, the layer (D) is referred to as an "adhesive resin layer (D)"). When the present multilayer structure includes the adhesive resin layer (D), the appearance characteristics (film surface) of the present multilayer structure tend to be more favorable.

The adhesive resin is not particularly limited, but a polyolefin having a carboxyl group, a carboxylic anhydride group, or an epoxy group is preferably used, and a polyolefin having a carboxylic anhydride group is more preferably used. Such an adhesive resin tends to exhibit excellent adhesion to the EVOH resin layer (A) and/or the thermoplastic resin layer (C).

Examples of the polyolefin containing a carboxyl group include polyolefins obtained by copolymerizing acrylic acid or methacrylic acid. In this case, all or some of the carboxyl groups contained in the polyolefin may be present in the form of a metal salt, as typified by ionomers. Examples of the polyolefin having a carboxylic anhydride group include polyolefins that have been graft-modified with maleic anhydride or itaconic acid. Examples of the polyolefin having an epoxy group include polyolefins obtained by copolymerizing glycidyl methacrylate. Among these, a polyolefin having a carboxylic anhydride group such as maleic anhydride can be preferably used, and a polyethylene having a carboxylic anhydride group can be particularly preferably used. One of these may be used alone or two or more thereof may be used in combination.

The melt flow rate (MFR) of the adhesive resin measured in accordance with JIS K7210:2014 (at 190°C with a load of 2160 g) is not particularly limited, but is preferably from 0.1 to 20.0 g/10 min, and more preferably from 1.0 to 10.0 g/10 min. When the MFR of the adhesive resin is in the above range, the molding stability tends to be more favorable.

The content of the adhesive resin in the adhesive resin layer (D) is not particularly limited, but the adhesive resin is preferably the main component (that is, the content of the adhesive resin contained in the adhesive resin layer (D) is 50 mass% or greater). The content of the adhesive resin is more preferably 60 mass% or greater, still more preferably 70 mass% or greater, and particularly preferably 80 mass% or greater, 90 mass% or greater, 95 mass% or greater, or 100 mass%.

For example, the adhesive resin layer (D) may contain, besides the adhesive resin, another component within a range that does not inhibit the effect of the present disclosure, and generally within a range of 20 mass% or less. Examples of other components include an anti-blocking agent, a processing aid, a resin other than an adhesive resin, a carboxylic acid compound, a phosphoric acid compound, a boron compound, a metal salt, a stabilizer, an antioxidant, an ultraviolet absorber, a plasticizer, an antistatic agent, a lubricant, a colorant, a filler, a surfactant, a desiccant, a crosslinking agent, and a reinforcing agent such as various fibers. One of these may be used alone or two or more thereof may be used in combination.

The thickness of the adhesive resin layer (D) (the thickness of one layer) is not particularly limited, but is usually from 0.1 to 20 µm, preferably from 0.5 to 10 µm, and more preferably from 1 to 5 µm. The thickness of the adhesive resin layer (D) means the thickness after stretching in a case of stretching.

### Production Method of Present Multilayer Structure

The present multilayer structure is produced by a production method that includes uniaxially stretching the EVOH resin layer (A) and laminating the inorganic vapor-deposited layer (B) on the EVOH resin layer (A).

### Uniaxially Stretching EVOH Resin Layer (A)

In the uniaxially stretching the EVOH resin layer (A), the EVOH resin composition for forming the EVOH resin layer (A) may be extrusion molded from a die and uniaxially stretched.

As the die, for example, a circular die, a T-die, or the like can be used.

The stretching ratio of the EVOH resin layer (A) is preferably 3 or more times, more preferably 4 or more times, and particularly preferably 5 or more times. When the stretching ratio is less than 3 times, thickness unevenness due to stretching tends to occur, and the gas barrier properties tend to decrease.

The upper limit of the stretching ratio is preferably 12 or less times, more preferably 10 or less times, and particularly preferably 8 or less times. When the stretching ratio exceeds 12 times, the film surface after stretching tends to deteriorate. Uniaxially stretching the EVOH resin layer (A) provides merits from an economical point of view, as well as merits such as easy tearing of the present multilayer structure (packaging materials being easy to open when the multilayer structure is used as a packaging material), and improvements in gas barrier properties.

The stretching direction of the uniaxial stretching is not particularly limited, and stretching may be implemented in the longitudinal direction (machine direction (MD)) or the width direction (transverse direction (TD)), and uniaxial stretching in the longitudinal direction (MD direction) is preferable. Preferably, the EVOH resin layer (A) is not substantially stretched in a direction different from the stretching direction.

The stretched state of the EVOH resin layer (A) can be confirmed by a general method for analyzing the orientation of a resin (for example, wide-angle X-ray scattering (WAXS), or the like).

The method for stretching the EVOH resin layer (A) is not particularly limited, and examples thereof include a tenter stretching method, a tubular stretching method, and a roll stretching method. Among these, from the viewpoint of production costs, uniaxial stretching by a roll stretching method is preferred.

The stretching temperature at which the EVOH resin layer (A) is uniaxially stretched is not particularly limited, but is generally from 50 to 130°C.

In a case in which the present multilayer structure includes the thermoplastic resin layer (C) and/or the adhesive resin layer (D), the compositions for forming the EVOH resin layer (A), the thermoplastic resin layer (C), and the adhesive resin layer (D) may be extrusion molded into a product in a film shape by a typical coextrusion lamination method in which each composition is extruded from a separate die or a common die and laminated, after which the product in a film shape may be uniaxially stretched to form a substrate film, and the inorganic vapor-deposited layer (B) is then laminated on the EVOH resin layer (A) of this substrate film by a method described below. Alternatively, after the present multilayer structure including the EVOH resin layer (A) and the inorganic vapor-deposited layer (B) has been produced, the thermoplastic resin layer (C) and/or the adhesive resin layer (D) may be laminated thereto.

As the die, for example, a circular die, a T-die, or the like can be used.

In addition to the coextrusion lamination method, the substrate film may be formed by extrusion molding each resin layer and then laminating each of these layers using various known production methods such as a dry lamination method, a sandwich lamination method, an extrusion lamination method, and a solution coating method.

The substrate film may include the EVOH resin layer (A) as the outermost layer, and the configuration of the other layers is not particularly limited, but when the EVOH resin layer (A) is referred to as "layer (A)", the thermoplastic resin layer (C) is referred to as "layer (C)", and the adhesive resin layer (D) is referred to as "layer (D)", examples of the layer configuration of the substrate film include layer (A) / layer (C), layer (A) / layer (D) / layer (C), layer (A) / layer (D) / layer (C) / layer (D) / layer (C), and layer (A) / layer (C) / layer (A) / layer (C).

In the above examples, the layer (C) and the layer (D) are exemplified as the layers other than the layer (A), but the other layers are not limited thereto. Moreover, the thermoplastic resin layer (C) preferably does not include a layer formed from a resin composition containing a polyamide resin as a main component (that is, the content of the polyamide resin contained in the resin composition is 50 mass% or greater). In the above examples, " / " means that the layers on both sides thereof are directly laminated.

The stretching method, the stretching ratio, and the like of the substrate film are as described in the step of uniaxially stretching the EVOH layer (A).

The total thickness of the substrate film is not particularly limited and may be appropriately set according to the application. The thickness of the substrate film is preferably 10 µm or greater, and more preferably 15 µm or greater. When the thickness of the substrate film is 10 µm or greater, industrial productivity and mechanical properties tend to be further improved. In addition, the thickness of the substrate film is preferably 100 µm or less, and more preferably 50 µm or less. When the thickness of the substrate film is 100 µm or less, industrial productivity and economic efficiency tend to be further improved. The thickness of the substrate film means the thickness after stretching.

When the substrate film is a multilayer film, the ratio of the thickness of the EVOH layer (A) to the total thickness of all the layers is not particularly limited, but from the viewpoints of industrial productivity and mechanical properties, the thickness ratio is preferably 30% or less, and more preferably 20% or less, and may be 10% or less or 5% or less.

The internal haze value of the EVOH resin layer (A) or the substrate film is preferably less than 0.4%, more preferably 0.3% or less, particularly preferably 0.2% or less, and especially preferably 0%. The internal haze value can be measured in accordance with ASTM D1003 using an EVOH resin layer (A) or a substrate film with a film thickness of 33 µm and a haze meter.

### Laminating Inorganic Vapor-Deposited layer (B) on EVOH Resin Layer (A)

The method for laminating the inorganic vapor-deposited layer (B) on the EVOH resin layer (A) is not particularly limited, and a known vapor deposition method may be appropriately employed, for example, a physical vapor deposition method (PVD method) such as a vacuum vapor deposition method, a sputtering method, or an ion plating method, or a chemical vapor deposition method (CVD method).

The oxygen permeability at 20°C and 90% RH of the present multilayer structure thus obtained is preferably 8 cc/m²·day·atm or less, more preferably 7 cc/m²·day·atm or less, and particularly preferably 5 cc/m²·day·atm or less.

The present multilayer structure can be suitably used as a molded body, a packaging material such as a packaging film, or as a portion of a multilayer structure for forming these to package general food products, as well as sauces and seasonings such as mayonnaise and dressings, fermented food products such as miso, salad oils and other oil and/or fat food products, snack foods, beverages, cosmetics, and pharmaceuticals.

### Molded Body

Examples of the molded body include containers such as cups and trays, and food containers. In a case of molding the container, food container, or the like, a drawing method is usually employed, and specific examples thereof include a vacuum forming method, a pressure forming method, a vacuum pressure forming method, and a plug-assisted vacuum pressure forming method.

Further, a blow molding method is adopted in a case of obtaining a multilayered container (laminate structure) in the form of a tube or bottle from a multilayered parison (a hollow tubular preform before blowing) using the present multilayer structure. Specific examples thereof include extrusion blow molding methods (such as dual-head type, mold-transfer type, parison shift type, rotary type, accumulator type, and horizontal parison type extrusion blow molding), a cold parison type blow molding method, an injection blow molding method, and a biaxial stretch blow molding method (such as an extrusion type cold parison biaxial stretch blow molding method, an injection type cold parison biaxial stretch blow molding method, and an injection molding in-line type biaxial stretch blow molding method). As necessary, the resulting laminate may be subjected to a heat treatment, a cooling treatment, a rolling treatment, a printing treatment, a dry lamination treatment, a solution or melt coating treatment, bag-making, deep drawing, box processing, tube processing, splitting, or the like.

### Examples

Hereinafter, the present disclosure will be more specifically described with reference to examples, but as long as a departure from the gist of the present disclosure does not occur, the present disclosure is not limited to the examples below. In the examples, "parts" and "%" are based on mass.

Prior to the examples, the following materials were prepared.

### EVOH

· EVOH resin 1: ethylene unit content of 29 mol%, MFR (at 210°C and a load of 2160 g) of 3.8 g/10 min, saponification degree of 99.9 mol%
· EVOH resin 2: ethylene unit content of 32 mol%, MFR (at 210°C and a load of 2160 g) of 3.8 g/10 min, saponification degree of 99.9 mol%
· EVOH resin 3: ethylene unit content of 25 mol%, MFR (at 210°C and a load of 2160 g) of 4.0 g/10 min, saponification degree of 99.9 mol%
· EVOH resin 4: ethylene unit content of 44 mol%, MFR (at 210°C and a load of 2160 g) of 3.5 g/10 min, saponification degree of 99.9 mol%

### Thermoplastic Resin

· Polyethylene: "Novatec HY540" available from Mitsubishi Chemical Corporation, MFR (at 190°C and a load of 2160 g) of 1.0 g/10 min

### Adhesive Resin

· Acid-modified polyethylene resin: "Modic M545" available from Mitsubishi Chemical Corporation, MFR (at 190°C and a load of 2160 g) of 6.0 g/10 min

### Example 1

### Production of Substrate Film

The EVOH resin 1, polyethylene, and an acid-modified polyethylene resin were supplied to a multilayer cast film device (available from PLABOR Research Laboratory of Plastics Technology Co., Ltd.) and coextruded under the following multilayer coextrusion molding conditions to obtain a substrate film having a three-layer configuration of three types of layers, namely EVOH resin layer / adhesive resin layer / polyethylene layer. The thicknesses (µm) of the respective layers of the obtained substrate film were 20 / 10 / 170.

### Multilayer Coextrusion Molding Conditions

· EVOH resin layer: 40 mm diameter single-screw extruder (barrel temperature of 210°C)
· Polyethylene layer: 40 mm diameter single-screw extruder (barrel temperature of 230°C)
· Adhesive resin layer: 32 mm diameter single-screw extruder (barrel temperature of 200°C)
· Die: feed block-type T-die of five layers of four types (die temperature of 230°C)
· Take-up speed: 5 m/min

The obtained substrate film was stretched 6 times in the longitudinal direction (MD direction) using a stretching device (available from MEC Techno Co., Ltd.) by passing the substrate film between a roll heated to a surface temperature (stretching temperature) of 120°C and another roll rotating at a different speed, and thereby a uniaxially stretched substrate film was obtained.

The thicknesses (µm) of the respective layers of the obtained substrate film were 3.3 / 1.7 / 28.3.

### Formation of Inorganic Vapor-Deposited Layer

An inorganic vapor-deposited layer of alumina was formed on the EVOH resin layer surface of the substrate film at a film surface temperature of 60°C or less using a batch-type vapor deposition apparatus available from Showa Shinku Co., Ltd., and a multilayer structure of Example 1 was obtained.

### Example 2

A multilayer structure of Example 2 was obtained in the same manner as in Example 1 with the exception that the EVOH resin to be used was changed to the EVOH resin 2.

### Example 3

A multilayer structure of Example 3 was obtained in the same manner as in Example 1 with the exception that alumina was changed to silica.

### Comparative Example 1

### Production of Substrate Film

The EVOH resin 1, polyethylene, and an adhesive resin were supplied to a multilayer cast film device (available from PLABOR Research Laboratory of Plastics Technology Co., Ltd.) and coextruded under the following multilayer coextrusion molding conditions to obtain a substrate film having a three layer configuration of three types of layers, namely EVOH resin layer / adhesive resin layer / polyethylene layer. The thicknesses (µm) of the respective layers of the obtained substrate film were 20 / 10 / 170.

### Multilayer Coextrusion Molding Conditions

· EVOH resin layer: 40 mm diameter single-screw extruder (barrel temperature of 210°C)
· Polyethylene layer: 40 mm diameter single-screw extruder (barrel temperature of 230°C)
· Adhesive resin layer: 32 mm diameter single-screw extruder (barrel temperature of 200°C)
· Die: feed block-type T-die of five layers of four types (die temperature of 230°C)
· Take-up speed: 5 m/min

The obtained multilayer film was stretched twice in the MD direction and 3 times in the TD direction for a total stretching of 6 times using a tenter type biaxial stretching machine (available from Bruckner Trockentechnik GmbH & Co. KG), and a biaxially stretched substrate film was obtained.

### Formation of Metal Vapor-Deposited Layer

A vapor-deposited layer of alumina was formed on the EVOH resin layer surface of the substrate film at a film surface temperature of 60°C or less using a batch-type vapor deposition apparatus available from Showa Shinku Co., Ltd., and a multilayer structure of Comparative Example 1 was obtained.

### Comparative Example 2

A multilayer structure of Comparative Example 2 was obtained in the same manner as in Comparative Example 1 with the exception that the EVOH resin to be used was changed to the EVOH resin 2.

### Comparative Example 3

A multilayer structure of Comparative Example 3 was obtained in the same manner as in Example 1 with the exception that the EVOH resin to be used was changed to a mixture of the EVOH resin 3 and the EVOH resin 4 at a mass ratio of 75:25.

The barrier properties were evaluated using the obtained vapor-deposited films of Examples 1 to 3 and Comparative Examples 1 to 3. The results are listed in Table 1 described below.

### Evaluation of Barrier Properties

The barrier properties were evaluated by measuring the oxygen permeability at 20°C and 90% RH using an oxygen permeability measurement apparatus (OX-TRAN 2/21, available from Hitachi High-Technologies Corporation).

**[Table 1]**

| | EVOH Resin | | Stretching | | Inorganic Vapor-Deposited Layer | Barrier Property Evaluation (cc/m²·day·atm) |
|---|---|---|---|---|---|---|
| | Type | Ethylene Unit Content (mol%) | Stretching method | Stretching Ratio | | |
| Example 1 | EVOH resin 1 | 29 | Uniaxial stretching | 6 | Alumina | 0.2 |
| Example 2 | EVOH resin 2 | 32 | Uniaxial stretching | 6 | Alumina | 0.2 |
| Example 3 | EVOH resin 1 | 29 | Uniaxial stretching | 6 | Silica | 2.6 |
| Comparative Example 1 | EVOH resin 1 | 29 | Biaxial stretching | 6 (2 × 3) | Alumina | 9 |
| Comparative Example 2 | EVOH resin 2 | 32 | Biaxial stretching | 6 (2 × 3) | Alumina | 31 |
| Comparative Example 3 | EVOH resin 3 + EVOH resin 4 | 30 (25 × 0.75 + 44 × 0.25) | Uniaxial stretching | 6 | Alumina | 0.8 |

The multilayer structures of Examples 1 to 3 each included an extrusion molded and uniaxially stretched substrate film provided with an EVOH resin layer (A) formed of an EVOH resin having a single ethylene unit content, and an inorganic vapor-deposited layer (B) on the surface of the EVOH resin layer (A) of the substrate film, and from the results in Table 1, it is clear that the multilayer structures of Examples 1 to 3 exhibited excellent barrier properties.

On the other hand, the multilayer structures of Comparative Examples 1 and 2, which used a substrate film provided with a biaxially stretched EVOH resin layer (A), and the multilayer structure of Comparative Example 3, which used two types of EVOH resins, were inferior in barrier properties in comparison to the multilayer structures of Examples 1 and 2 in which the inorganic vapor-deposited layer was the same alumina.

Specific embodiments of the present disclosure were described in the above examples, but the above examples are merely illustrative and are not to be construed as limiting. Various modifications apparent to those skilled in the art are intended to be within the scope of the present disclosure.

### Industrial Applicability

The present multilayer structure can be suitably used as a molded body, a packaging material such as a packaging film, or as a portion of a multilayer structure for forming these to package general food products, as well as sauces and seasonings such as mayonnaise and dressings, fermented food products such as miso, salad oils and other oil and/or fat food products, snack foods, beverages, cosmetics, and pharmaceuticals.

## Claims

1. A multilayer structure comprising:
a layer (A) comprising an ethylene-vinyl alcohol copolymer; and
an inorganic vapor-deposited layer (B) adjacent to the layer (A),
wherein the layer (A) is extrusion molded and uniaxially stretched, and
wherein the ethylene-vinyl alcohol copolymer has a single ethylene unit content.

2. The multilayer structure according to claim 1, wherein the inorganic vapor-deposited layer (B) comprises an inorganic oxide and/or an inorganic nitride.

3. The multilayer structure according to claim 1, wherein a stretching ratio of the layer (A) is 3 or more times.

4. The multilayer structure according to claim 1 or 2, a layer (C) comprising a thermoplastic resin.

5. The multilayer structure according to claim 4, wherein the thermoplastic resin comprises a polyolefin.

6. A molded body comprising the multilayer structure according to claim 1 or 2.

7. A container comprising the multilayer structure according to claim 1 or 2.

8. A food container comprising the multilayer structure according to claim 1 or 2.

9. A method for producing a multilayer structure, the method comprising:
uniaxially stretching a layer (A) comprising an ethylene-vinyl alcohol copolymer; and
laminating an inorganic vapor-deposited layer (B) on the layer (A).
